(19) Europäisches Patentamt
European Patent Office
Office européen des brevets

(11) EP 1 070 965 B1

(12) **EUROPEAN PATENT SPECIFICATION**

(45) Date of publication and mention of the grant of the patent:
**28.11.2007 Bulletin 2007/48**

(51) Int Cl.:
***G01R 19/00*** *(2006.01)* ***G01R 19/255*** *(2006.01)*

(21) Application number: **00113098.8**

(22) Date of filing: **27.06.2000**

(54) **Method for measuring an electric voltage and arrangement for implementing the method**

Verfahren zum Messen einer elektrischen Spannung und Anordnung zur Durchführung des Verfahrens

Procédé pour mesurer une tension éléctrique et ensemble pour mettre en oeuvre ledit procédé

(84) Designated Contracting States:
**AT BE CH CY DE DK ES FI FR GB GR IE IT LI LU MC NL PT SE**

(30) Priority: **30.06.1999 DE 19930149**

(43) Date of publication of application:
**24.01.2001 Bulletin 2001/04**

(73) Proprietor: **TEXAS INSTRUMENTS DEUTSCHLAND GMBH**
**85356 Freising (DE)**

(72) Inventor: **Bierl, Lutz**
**85435 Erding (DE)**

(74) Representative: **Degwert, Hartmut et al**
**Prinz & Partner GbR**
**Rundfunkplatz 2**
**80335 München (DE)**

(56) References cited:
**EP-A- 0 127 139**
**EP-A- 0 437 951**
**EP-A- 0 884 600**
**US-A- 5 657 238**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

The invention relates to a method for measuring an electric voltage by making use of a microcomputer connected to a supply voltage, the invention also relating to an arrangement for implementing this method.

A method for voltage measurement is described in the magazine "electronic industry", Issue No. 2, 1999, pages 24 to 32 in which the microcomputer type M3P430 of the Company Texas Instruments Inc. is used as the central module. In the version described in this application the microcomputer comprises a measurement input formed by the input of a comparator, the threshold voltage of which is precisely known. Connected between the measurement input and the ground terminal of the microcomputer is a measuring capacitor which in subsequent cycles of a sequence is first charged to the voltage to be measured, then discharged, before then being charged to the value of the supply voltage of the microcomputer and finally being again discharged. Every time the capacitor is discharged the microcomputer measures how long it takes until the charging voltage of the measuring capacitor has dropped in a discharge cycle from the voltage to be measured to the threshold voltage of the comparator, and in the other discharge cycle from the supply voltage likewise to the threshold voltage of the comparator. Measuring these time periods is simply achieved by a counter being started every time a discharge action is commenced, the counter not being halted until the charging voltage at the measuring capacitor has dropped below the threshold voltage of the comparator in the microcomputer. Each count is then a measure of the time duration required for the discharge action. Although the desired voltage value could be calculated already from a single time measurement, since the time constant of the discharge action can be computed from the values of the measuring capacitor and the resistors in the discharge cycle, however, this time constant is sensitive to environmental influencing factors, more particularly temperature, and ageing of the components in the discharge circuit. Implementing two discharge actions permits eliminating the time constant $\tau$ from the calculation so that the result of the measurement is no longer a function of the cited influencing factors. However, the known measurement method requires the existence of a comparator having a precisely known threshold voltage in the microcomputer. EP 0884600 discloses a device and process for monitoring the state of charge of a battery. A microprocessor-controlled arithmetic unit is connected in parallel to the terminal voltage of the battery. A desired value of the time difference between the occurrence of first and second threshold voltages is compared to a measured value of the time difference using a comparator specified in the microprocessor. When the measured value exceeds the desired value, an unacceptably low residual state of charge is assumed to exist. New generations of microcomputers are now available, however, in which a comparator input having a precisely known threshold voltage no longer exists. These microcomputers have simply an input connected to the input of a Schmitt trigger, this Schmitt trigger comprising two switching thresholds, namely an upper and a lower threshold. In this arrangement the thresholds are not particularly accurate and also the hysteresis existing between the two thresholds is not constant.

The invention is thus based on the object of providing a method and an arrangement for measuring an electric voltage by making use of a microcomputer which has no comparator input with a precisely known threshold.

In accordance with the invention this object is achieved by application of the methods as they read from claim 1 and claim 3. For implementing these methods arrangements are made use of as they read from claims 2 and 4 respectively.

In the method in accordance with the invention three discharge actions of the measuring capacitor are implemented with known initial and final discharge conditions so that three discharge time periods can be measured. On the basis of these three discharge time periods in calculating the wanted voltage value, not only the discharge time constant but also the upper switching threshold of the Schmitt trigger used to define the starting time point in the discharge time measurement can be eliminated so that the measurement result is now a function of but three sensed discharge time periods. In this way by making use of a cost-effective microcomputer a precise measured value is obtainable for the wanted voltage which is independent of environmental and ageing influencing factors.

An example embodiment of the invention will now be detailed with reference to the drawing in which:

Fig. 1 is circuit diagram of an arrangement for implementing the measurement method in accordance with the invention and

Fig. 2 is a time plot of the voltage at the measuring capacitor, the response of the circuit as shown in Fig. 1 being indicated at each period in time.

Referring now to Fig. 1 there is illustrated a measurement circuit comprising as its central element a microcomputer 10 which in this case is the type MSP430 of Texas Instruments. In the subsequent discussion of the measurement method it is sufficient to consider four terminals of this microcomputer 10. It firstly comprises a ground terminal 12 for the application of the ground potential Vss as well as a supply voltage terminal 14 for applying the supply voltage Vcc. In addition, it has a control signal terminal 16 and a measurement terminal 18. The microcomputer 10 is able to set the control signal terminal 16 HI; it also being able to connect this terminal to the supply voltage Vcc or to ground

potential Vss, however. The measurement terminal 18 is the input of a Schmitt trigger incorporated in the microcomputer 10, this Schmitt trigger having an upper switching threshold $V_{IT+}$ and a lower switching threshold $V_{IT-}$. This Schmitt trigger is a circuit whose output signal changes from a first value to a second value when its input voltage exceeds the upper switching threshold whilst the output voltage does not revert from the second value to the first value until the input voltage has dropped below the lower switching threshold. The Schmitt trigger thus comprises a switching hysteresis and thus differs from a comparator which changes its output signal every time its comparator threshold voltage is violated. Since in the aforementioned microcomputer MSP430 only a minor circuitry expense is involved for the Schmitt trigger to maintain production costs low the switching thresholds are very inaccurate, this also applying to the difference between the upper and lower switching threshold.

As evident from Fig. 1 the microcomputer 10 is connected to a measurement circuit comprising a series connection of a first resistor R1, a second resistor R2 and a measuring capacitor Cm. The connecting point between the resistor R1 and the resistor R2 is connected to the control signal terminal 16 whilst the connecting point between the resistor R2 and the measuring capacitor Cm is connected to the measurement terminal 18 via a third resistor R3. The voltage Vin to be measured is applied to one end of the aforementioned series circuit, the other end of which is connected to ground.

Referring now to Fig. 2 there is illustrated the circuit as shown in Fig. 1 to assist in explaining how the voltage Vin can be measured. In the idle condition of the circuit, i.e. before commencing the voltage measurement the Schmitt trigger is in its reset state.

In a first step it is ensured that the measuring capacitor Cm is charged to a voltage proportional to the voltage vin to be measured by the microcomputer 10 setting its control signal terminal 16 into a high impedance state and setting its measurement terminal 18 to ground potential so that the resistors R1, R2 and R3 form a voltage divider, to the tap of which - formed by the connecting point of the resistors R2 and R3 - the measuring capacitor Cm is connected. The measurement circuit thus responds as shown in time period A in Fig. 2. In this arrangement the voltage to which the measuring capacitor Cm charges is k·Vin where k is the proportionality factor resulting as follows:

$$k = \frac{R3}{R1 + R2 + R3}$$

As evident from Fig. 2 the resulting value k·Vin of the charging voltage of the capacitor Cm lies below the lower switching threshold $V_{IT-}$ of the Schmitt trigger connected to the measurement terminal 18.

In the next step the microcomputer 10 applies the supply voltage to its control signal terminal 16, and it uses its measurement terminal 18 as the input of the Schmitt trigger incorporated therein. In this arrangement the measurement circuit connected to the microcomputer 10 has the configuration as shown in time period B of Fig. 2 in which the measuring capacitor Cm is charged starting from the already existing charging voltage. On commencement of the charging action the microcomputer 10 starts a time measurement action which may involve, for example, a counter being started. As soon as the charging voltage of the measuring capacitor Cm has attained the upper switching threshold $V_{IT+}$ of the Schmitt trigger on timeout of the time duration *tin*, the latter changes to its other condition, resulting in the counter previously started in the microcomputer 10 being halted. In this way a count proportional to the time duration *tin* is attained which due to the fixed clock rate with which the counter increments, also contains a direct indication as to the time duration *tin*. This time duration *tin* is stored in the microcomputer 10.

In a next step in the method the measuring capacitor Cm is discharged down to a reference voltage value Vref by the microcomputer 10 applying the supply voltage Vcc to its control signal terminal 16 and outputting ground potential at its measurement terminal. In this arrangement the outer circuit configuration of the microcomputer 10 assumes the configuration as shown in time period C in Fig. 2. In the example as described the reference voltage Vref lies below the lower switching threshold $V_{IT-}$ of the Schmitt trigger, resulting in the latter toggling to its original switching condition.

In one modification of this step in the method it is also possible to revert the Schmitt trigger to its original switching condition internally in the microcomputer 10, resulting in the reference voltage also having a value exceeding the lower switching threshold of the series circuit. The subsequent repeat charging action of the measuring capacitor to be implemented could then commence from a higher voltage value so that it takes less time.

However, in the example discussed in this case it is assumed in accordance with the plot as shown in Fig. 2 that the reference voltage Vref is lower than the lower switching threshold $V_{IT-}$ of the Schmitt trigger. In this arrangement the time duration tchref indicated in the graph as shown in Fig. 2 is selected so long that the discharge of the capacitor Cm reliably occurs at the reference voltage Vref.

The microcomputer 10 now starts a new charging action of the measuring capacitor Cm by it outputting at its control terminal 16 again the supply voltage Vcc and using its measurement terminal 18 as the Schmitt trigger input. The outer circuit of the microcomputer 10 is then as configured in time period D of Fig. 2.

On commencement of this step in the microcomputer 10 a counter is again started which is incremented during the charging action of the measuring capacitor Cm until the charging voltage attains the upper switching threshold of the Schmitt trigger, At this point in time the Schmitt trigger changes to its other switching condition, resulting in the counter being halted. The count attained at this time is proportional to the time duration tref as indicated in Fig. 2. The count corresponding to the time duration tref is stored in the microcomputer 10.

Then, the measuring capacitor Cm is again discharged, this discharge action continuing until the charging voltage corresponds to the ground potential. This is achieved by the microcomputer 10 grounding its control signal terminal and its measurement terminal so that outer circuit of the microcomputer 10 is then as configured in time period E of Fig. 2. The time required for this discharge is indicated in the plot as the time duration tchvcc.

The next step in the method consists of the measuring capacitor Cm being charged until its charging voltage exceeds the upper switching threshold of the Schmitt trigger. Charging the measuring capacitor Cm is achieved by the control terminal 16 being connected to the supply voltage Vcc whilst the measurement terminal 18 is used as the input of the Schmitt trigger. The circuit of the microcomputer 10 is then as configured in time period F of Fig. 2. The same as before, the time duration needed for charging the measuring capacitor Cm is memorized by making use of a counter incremented in the microcomputer 10, the count attained when the charging voltage of the measuring capacitor Cm exceeds the upper switching threshold of the Schmitt trigger being proportional to the time duration tvcc.

After implementation of this step in the method three counts are available in the memory of the microcomputer 10, directly corresponding to the time duration tin, the time duration tref and the time duration tvcc.

In application of the known formulae for charging of a capacitor the time durations tin, tref and tvcc may be written as follows:

$$tin = -\tau \cdot \ln\left(1 - \frac{V_{IT+} - k \cdot Vin}{Vcc - k \cdot Vin}\right)$$

$$tref = -\tau \cdot \ln\left(1 - \frac{V_{IT+} - Vref}{Vcc - Vref}\right)$$

$$tvcc = -\tau \cdot \ln\left(1 - \frac{V_{IT+}}{Vcc}\right)$$

In these equations:

$$\mathrm{Vref} = \mathrm{Vcc} \cdot \frac{\mathrm{R3}}{\mathrm{R2} + \mathrm{R3}}$$

$$\mathrm{k} = \frac{\mathrm{R3}}{\mathrm{R1} + \mathrm{R2} + \mathrm{R3}}$$

From the above equations the unknown variables $\tau$ and $V_{IT+}$ can be eliminated so that the voltage Vin to be measured is given by the following formula:

$$\mathrm{Vin}=\frac{R1+R2+R3}{\mathrm{R3}}\cdot Vcc\cdot\left(1-e^{\left(1-\frac{tin-tref}{tvcc-tref}\right)\cdot\ln\left(\frac{R2}{R2+R3}\right)}\right)$$

As evident from this formula it is in this way that in measuring the voltage Vin both the effect of the time constant T as well as the effect of the switching threshold $V_{IT+}$ are eliminated so that a result is obtained which is independent of just the variables which, on the one hand, are inaccurate and, on the other, are variable due to ageing of the components and the effects of temperature.

With the aid of the method as described it is, of course, not only possible to measure an unknown voltage Vin but also other parameters can be measured as may be represented by a voltage. For example, an unknown current may be measured by connecting a known measurement resistor between the terminal of the circuit as shown in Fig. 1 at which the voltage to be measured Vin is connected and ground, this measurement resistor being in the flow of the current to be measured. The voltage proportional to the current is then represented as the voltage Vin' which can then be measured by making use of the method as described above, i.e. the desired current value then materializing from this measured value.

Calculating the voltage to be measured by making use of the formula as given above is implemented by the microcomputer utilizing a program stored therein.

The described method makes it possible to use a microcomputer which need not contain a complicated comparator with a known switching threshold, but merely a Schmitt trigger which is achievable at substantially less expense so that the microcomputer can be produced, in all, more cost-effectively.

## Claims

**1.** A method for measuring an electric voltage by making use of a microcomputer (10) connected to a supply voltage (Vcc), the microcomputer (10) utilizing as the measurement input the input of a Schmitt trigger comprising an upper (VIT+) and a lower (VIT) switching threshold, comprising the steps:

a) charging a measuring capacitor (Cm) in connection with the measurement input (18) to a measured value proportional to the voltage to be measured, the measured voltage being smaller than the upper switching threshold (VIT+) of the Schmitt trigger,
b) continuing charging of the measuring capacitor (Cm) from the achieved charging voltage until its charging voltage exceeds the upper switching threshold (VIT+) of the Schmitt trigger, the first time duration (tin) needed for this being measured,
c) charging the measuring capacitor (Cm) to a known reference voltage (Vref) proportional to the supply voltage (Vcc) of the microcomputer (10), the reference voltage being smaller than the lower switching threshold (VIT-) of the Schmitt trigger,
d) charging the measuring capacitor (Cm) with the reference voltage (Vref) until its charging voltage exceeds the upper switching threshold (VIT+) of the Schmitt trigger, the second time duration (tref) needed for this being measured,
e) discharging the measuring capacitor (Cm) fully,
f) charging the measuring capacitor (Cm) until its charging voltage exceeds the upper switching threshold (VIT+) of the Schmitt trigger, the third time duration (tvcc) needed for this being measured,
g) calculating the value of the voltage to be measured from the following formula;

$$\mathrm{Vin}=\frac{1}{\mathrm{k}}\cdot Vcc\cdot\left(1-e^{\left(1-\frac{tin-tref}{tvcc-tref}\right)\cdot\ln\left(\frac{R2}{R2+R3}\right)}\right)$$

where:

Vcc = supply voltage of the microcomputer
Vref = p · Vcc (p < 1)

k = proportionality factor between the voltage to be measured and the voltage applied to the measurement input (k<1)
tin = first time duration
tref = second time duration
tvcc = third time duration.

**2.** An arrangement for implementing the method as set forth in claim 1 wherein in addition to its measurement input (18) the microcomputer (10) comprises a supply voltage terminal (14), a ground terminal (12) and a control signal output (16), a first resistor (R1) being connected between one input (Vin) for applying the voltage to be measured and the control signal output (16), a second resistors (R2) being connected in series between the control signal output (16) and the ground terminal (12) and a third resistor (R3) being connected between the measurement input (18) and the connecting point of the second resistor (R2) and the measuring capacitor (Cm), and the microcomputer (10) being configured so that it
signals the control signal output (16) HI and connects the measurement input (18) to ground potential for step a) in the method,
outputs at the control signal output (16) the supply voltage and applies the charging voltage of the measuring capacitory (Cm) connected to the measurement input (18) to the Schmitt trigger input for step b) in the method,
outputs at the control signal output (16) the supply voltage and sets ground potential at the measurement input (18) for step c) in the method,
outputs at the control signal output (16) the supply voltage and applies the charging voltage of the measuring capacitor (Cm) connected to the measurement input (18) to the Schmitt trigger input for step d) in the method
places both the control signal output (16) and the measurement input (18) at ground potential for step e) in the method,
outputs at the control signal output (16) the supply voltage (Vcc) and applies the charging voltage of the measuring capacitor (Cm) connected to the measurement input (18) to the Schmitt trigger input for step f) in the method, and
calculates in its arithmetic unit the value of the voltage to be measured for step g) in the method.

**3.** An arrangement for implementing the method as set forth in claim 1 wherein in addition to its measurement input (18) the microcomputer (10) comprises a supply voltage terminal (14), a ground terminal (12) and a control signal output (16), a first resistor (R1) being connected between one input (Vin) for applying the voltage to be measured and the control signal output (16), a second resistor (R2) being connected in series between the control signal output (16) and the ground terminal (12) and a third resistor (R3) being connected between the measurement input (18) and the connecting point of the second resistor (R2) and the measuring capacitor (Cm), and the microcomputer (10) being configured so that it
signals the control signal output (16) HI and connects the measurement input (18) to ground potential for step a) in the method,
outputs at the control signal output (16) the supply voltage and applies the charging voltage of the measuring capacitor (Cm) connected to the measurement input (18) to the Schmitt trigger input for step b) in the method,
returns the Schmitt trigger to its starting condition for step c) in the method,
outputs at the control signal output (16) the supply voltage and sets ground potential at the measurement input (18) for step d) in the method,
outputs at the control signal output (16) the supply voltage (Vcc) and applies the charging voltage of the measuring capacitor (Cm) connected to the measurement input (18) to the Schmitt trigger input for step e) in the method,
places both the control signal output (16) and the measurement input (18) at ground potential for step f) in the method,
outputs at the control signal output (16) the supply voltage (Vcc) and applies the charging voltage of the measuring capacitor (Cm) connected to the measurement input (18) to the Schmitt trigger input for step g) in the method, and
calculates in its arithmetic unit the value of the voltage to be measured for step h) in the method.

**Patentansprüche**

**1.** Verfahren zum Messen einer elektrischen Spannung unter Verwendung eines an einer Versorgungsspannung (Vcc) liegenden Mikrocomputers (10), der als Meßeingang den Eingang eines SCHMITT-Triggers benutzt, der einen oberen ($V_{IT+}$) und einen unteren ($V_{IT-}$) Umschaltschwellenwert aufweist, bei dem

a) ein mit dem Meßeingang (18) in Verbindung stehender Meßkondensator (Cm) auf eine zur zu messenden Spannung proportionale Meßspannung geladen wird, die kleiner als der obere Umschaltschwellenwert ($V_{IT+}$) des SCHMITT-Triggers ist,
b) der Meßkondensator (Cm) von der erreichten Ladespannung aus so lange weitergeladen wird, bis seine

Ladespannung den oberen Umschaltschwellenwert ($V_{IT+}$) des SCHMITT-Triggers überschreitet, wobei die dazu benötigte erste Zeitdauer (tin) gemessen wird,
c) der Meßkondensator (Cm) auf eine bekannte, zur Versorgungsspannung (Vcc) des Mikrocomputers (10) proportionale Referenzspannung (Vref) geladen wird, die kleiner als der untere Umschaltschwellenwert ($V_{IT-}$) des SCHMITT-Triggers ist,
d) der Meßkondensator (Cm) mit der Referenzspannung (Vref) geladen wird, bis seine Ladespannung den oberen Umschaltschwellenwert ($V_{IT+}$) des SCHMITT-Triggers überschreitet, wobei die dazu benötigte zweite Zeitdauer (tref) gemessen wird,
e) der Meßkondensator (Cm) vollständig entladen wird,
f) der Meßkondensator (Cm) aufgeladen wird, bis seine Ladespannung den oberen Umschaltschwellenwert ($V_{IT+}$) des SCHMITT-Triggers überschreitet, wobei die dazu benötigte dritte Zeitdauer (tvcc) gemessen wird,
g) der Wert der zu messenden Spannung aus der folgenden Formel berechnet wird:

$$\mathrm{Vin} = \frac{1}{\mathrm{k}} \cdot Vcc \cdot \left( 1 - e^{\left(1 - \frac{tin - tref}{tvcc - tref}\right) \cdot \ln\left(\frac{R2}{R2 + R3}\right)} \right)$$

mit: Vcc = Versorgungsspannung des Mikrocomputers

Vref = p • Vcc (p < 1)
k = Proportionalitätsfaktor zwischen der zu messenden Spannung und der dem Meßeingang zugeführten Spannung (k<1)
tin = erste Zeitdauer
tref = zweite Zeitdauer
tvcc = dritte Zeitdauer.

**2.** Anordnung zur Durchführung des Verfahrens nach Anspruch 1, bei der der Mikrocomputer (10) zusätzlich zu seinem Meßeingang (18) einen Versorgungsspannungsanschluß (14), einen Masseanschluß (12) und einen Steuersignalausgang (16) aufweist, wobei zwischen einem Eingang (Vin) zum Anlegen der zu messenden Spannung und dem Steuersignalausgang (16) ein erster Widerstand (R1), zwischen dem Steuersignalausgang (16) und dem Masseanschluß (12) in Serie ein zweiter Widerstand (R2) sowie zwischen dem Meßeingang (18) und dem Verbindungspunkt des zweiten Widerstandes (R2) mit dem Meßkondensator (Cm) ein dritter Widerstand (R3) liegen, und wobei der Mikrocomputer (10) so ausgebildet ist, daß er
für den Verfahrensschritt a) den Steuersignalausgang (16) hochohmig macht und den Meßeingang (18) auf Massepotential legt,
für den Verfahrensschritt b) am Steuersignalausgang (16) die Versorgungsspannung abgibt und die am Meßeingang (18) anliegende Ladespannung des Meßkondensators (Cm) dem SCHMITT-Triggereingang zuführt,
für den Verfahrensschritt c) am Steuersignalausgang (16) die Versorgungsspannung abgibt und am Meßeingang (18) das Massepotential einstellt,
für den Verfahrensschritt d) am Steuersignalausgang (16) die Versorgungsspannung abgibt und die am Meßeingang (18) anliegende Ladespannung des Meßkondensators (Cm) dem SCHMITT-Triggereingang zuführt,
für den Verfahrensschritt e) sowohl den Steuersignalausgang (16) als auch den Meßeingang (18) auf Massepotential legt,
für den Verfahrensschritt f) am Steuersignalausgang (16) die Versorgungsspannung (Vcc) abgibt und die am Meßeingang (18) anliegende Ladespannung des Meßkondensators (Cm) dem SCHMITT-Triggereingang zuführt und
für den Verfahrensschritt g) in seinem Rechenwerk den Wert der zu messenden Spannung berechnet.

**3.** Anordnung zur Durchführung des Verfahrens nach Anspruch 1, bei der der Mikrocomputer (10) zusätzlich zu seinem Meßeingang (18) einen Versorgungsspannungsanschluß (14), einen Masseanschluß (12) und einen Steuersignalausgang (16) aufweist, wobei zwischen einem Eingang (Vin) zum Anlegen der zu messenden Spannung und dem Steuersignalausgang (16) ein erster Widerstand (R1), zwischen dem Steuersignalausgang (16) und dem Masseanschluß (12) in Serie ein zweiter Widerstand (R2) sowie zwischen dem Meßeingang (18) und dem Verbindungspunkt des zweiten Widerstandes (R2) mit dem Meßkondensator (Cm) ein dritter Widerstand (R3) liegen, und wobei der Mikrocomputer (10) so ausgebildet ist, daß er

für den Verfahrensschritt a) den Steuersignalausgang (16) hochohmig macht und den Meßeingang (18) auf Massepotential legt,
für den Verfahrensschritt b) am Steuersignalausgang (16) die Versorgungsspannung abgibt und die am Meßeingang (18) anliegende Ladespannung des Meßkondensators (Cm) dem SCHMITT-Triggereingang zuführt,
für den Verfahrensschritt c) den SCHMITT-Trigger in seinen Anfangszustand zurückversetzt,
für den Verfahrensschritt d) am Steuersignalausgang (16) die Versorgungsspannung abgibt und am Meßeingang (18) das Massepotential einstellt,
für den Verfahrensschritt e) am Steuersignalausgang (16) die Versorgungsspannung (Vcc) abgibt und die am Meßeingang (18) anliegende Ladespannung des Meßkondensators (Cm) dem SCHMITT-Triggereingang zuführt,
für den Verfahrensschritt f) sowohl den Steuersignalausgang (16) als auch den Meßeingang (18) auf Massepotential legt,
für den Verfahrensschritt g) am Steuersignalausgang (16) die Versorgungsspannung (Vcc) abgibt und die am Meßeingang (18) anliegende Ladespannung des Meßkondensators (Cm) dem SCHMITT-Triggereingang zuführt und
für den Verfahrensschritt h) in seinem Rechenwerk den Wert der zu messenden Spannung berechnet.

## Revendications

**1.** Procédé pour mesurer une tension électrique en utilisant un micro-ordinateur (10) connecté à une tension d'alimentation (Vcc), le micro-ordinateur (10) utilisant comme entrée de mesure l'entrée d'une bascule de Schmitt comprenant un seuil de commutation supérieur (VIT+) et inférieur (VIT-), comprenant les étapes consistant à :

(a) charger un condensateur de mesure (Cm) en connexion avec l'entrée de mesure (18) à une valeur mesurée proportionnelle à la tension à mesurer, la tension mesurée étant inférieure au seuil de commutation supérieur (VIT+) de la bascule de Schmitt,
(b) continuer le chargement du condensateur de mesure (Cm) à partir de la tension de charge obtenue jusqu'à ce que sa tension de charge dépasse le seuil de commutation supérieur (VIT+) de la bascule de Schmitt, la première durée (tin) nécessaire à ceci étant mesurée,
(c) charger le condensateur de mesure (Cm) à une tension de référence connue (Vref) proportionnelle à la tension d'alimentation (Vcc) du micro-ordinateur (10), la tension de référence étant inférieure à la tension de commutation inférieure (VIT-) de la bascule de Schmitt,
(d) charger le condensateur de mesure (Cm) avec la tension de référence (Vref) jusqu'à ce que sa tension de charge dépasse le seuil de commutation supérieur (VIT+) de la bascule de Schmitt, la deuxième durée (tref) nécessaire à ceci étant mesurée,
(e) décharger entièrement le condensateur de mesure (Cm),
(f) charger le condensateur de mesure (Cm) jusqu'à ce que sa tension de charge dépasse le seuil de commutation supérieur (VIT+) de la bascule de Schmitt, la troisième durée (tvcc) nécessaire à ceci étant mesurée,
(g) calculer la valeur de la tension à mesurer d'après la formule suivante :

$$Vin = \frac{1}{k}.Vcc\left(1 - e^{\left(1-\frac{tin-tref}{tvcc-tref}\right).\ln\left(\frac{R2}{R2+R3}\right)}\right)$$

où :

Vcc = tension d'alimentation du micro-ordinateur
Vref = p. Vcc (p < 1)
k = facteur de proportionnalité entre la tension à mesurer et la tension appliquée à l'entrée de mesure (k<1)
tin = première durée
tref = deuxième durée
tvcc = troisième durée

**2.** Ensemble pour mettre en oeuvre le procédé tel que défini dans la revendication 1, dans lequel en plus de son entrée

de mesure (18), le micro-ordinateur (10) comprend une borne de tension d'alimentation, (14), une borne de masse (12) et une sortie de signal de commande (16), une première résistance (R1) étant connectée entre une entrée (Vin) permettant d'appliquer la tension à mesurer et la sortie de signal de commande (16), une deuxième résistance (R2) étant connectée en série entre la sortie de signal de commande (16) et la borne de masse (12) et une troisième résistance (R3) étant connectée entre l'entrée de mesure (18) et le point de connexion de la deuxième résistance (R2) et du condensateur de mesure (Cm), et le micro-ordinateur (10) étant configuré de telle sorte qu'il :

signale la sortie de signal de commande (16) HI et connecte l'entrée de mesure (18) au potentiel de masse pour l'étape a) du procédé,
délivre à la sortie de signal de commande (16) la tension d'alimentation et applique la tension de charge du condensateur de mesure (Cm) connecté à l'entrée de mesure (18) à l'entrée de la bascule de Schmitt pour l'étape b) du procédé,
délivre à la sortie de signal de commande (16) la tension d'alimentation et positionne au potentiel de masse l'entrée de mesure (18) pour l'étape c) du procédé,
délivre à la sortie de signal de commande (16) la tension d'alimentation et applique la tension de charge du condensateur de mesure (Cm) connecté à l'entrée de mesure (18) à l'entrée de la bascule de Schmitt pour l'étape d) du procédé,
positionne à la fois la sortie de signal de commande (16) et l'entrée de mesure (18) au potentiel de masse pour l'étape e) du procédé,
délivre à la sortie de signal de commande (16) la tension d'alimentation (Vcc) et applique la tension de charge du condensateur de mesure (Cm) connecté à l'entrée de mesure (18) à l'entrée de la bascule de Schmitt pour l'étape f) du procédé, et
calcule dans son unité arithmétique la valeur de la tension à mesurer pour l'étape g) du procédé.

**3.** Ensemble pour mettre en oeuvre le procédé tel que défini dans la revendication 1, dans lequel en plus de son entrée de mesure (18), le micro-ordinateur (10) comprend une borne de tension d'alimentation (14), une borne de masse (12) et une sortie de signal de commande (16), une première résistance (R1) étant connectée entre une entrée (Vin) permettant d'appliquer la tension à mesurer et la sortie de signal de commande (16), une deuxième résistance (R2) étant connectée en série entre la sortie de signal de commande (16) et la borne de masse (12), et une troisième résistance (R3) étant connectée entre l'entrée de mesure (18) et le point de connexion de la deuxième résistance (R2) et du condensateur de mesure (Cm), et le micro-ordinateur (10) étant configuré de telle sorte qu'il :

signale la sortie de signal de commande (16) HI et connecte l'entrée de mesure (18) au potentiel de masse pour l'étape a) dans le procédé,
délivre à la sortie de signal de commande (16) la tension d'alimentation et applique la tension de charge du condensateur de mesure (Cm) connecté à l'entrée de mesure (18) à l'entrée de la bascule de Schmitt pour l'étape b) du procédé,
renvoie la bascule de Schmitt à son état de départ pour l'étape (c) du procédé, délivre à la sortie de signal de commande (16) la tension d'alimentation et positionne au potentiel de masse l'entrée de mesure (18) pour l'étape d) du procédé,
délivre à la sortie de signal de commande (16) la tension d'alimentation (Vcc) et applique la tension de charge du condensateur de mesure (Cm) connecté à l'entrée de mesure (18) à l'entrée de la bascule de Schmitt pour l'étape e) du procédé,
positionne à la fois la sortie de signal de commande (16) et l'entrée de mesure (18) au potentiel de masse pour l'étape f) du procédé,
délivre à la sortie de signal de commande (16) la tension d'alimentation (Vcc) et applique la tension de charge du condensateur de mesure (Cm) connecté à l'entrée de mesure (18) à l'entrée de la bascule de Schmitt pour l'étape g) du procédé, et
calcule dans son unité arithmétique la valeur de la tension à mesurer pour l'étape h) du procédé.

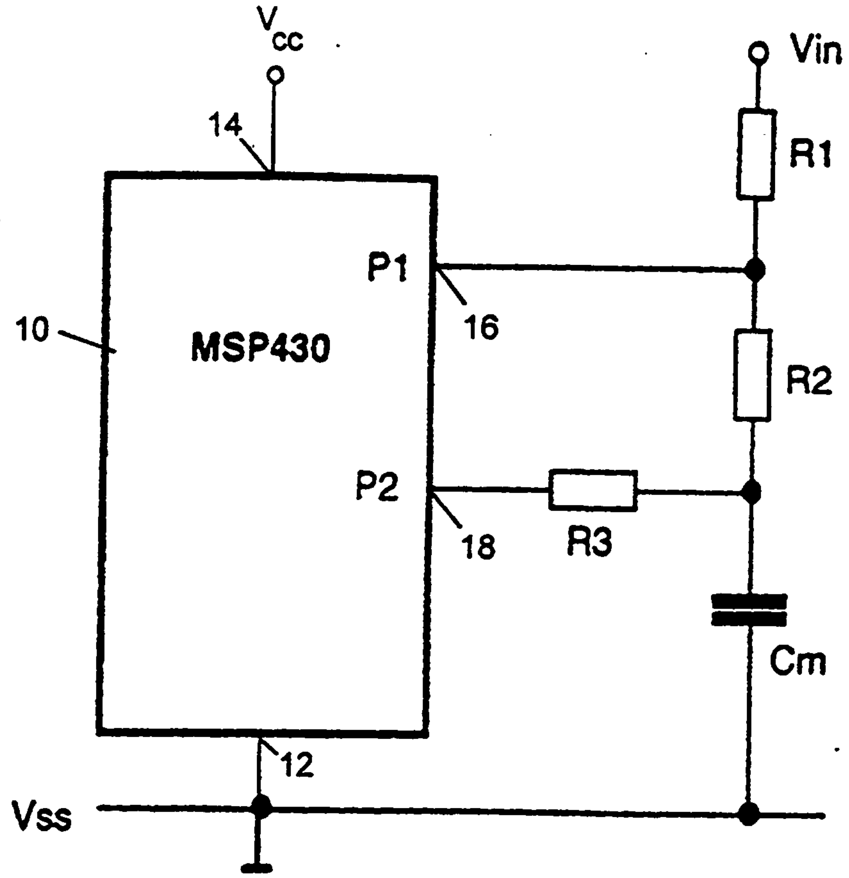


Fig. 1

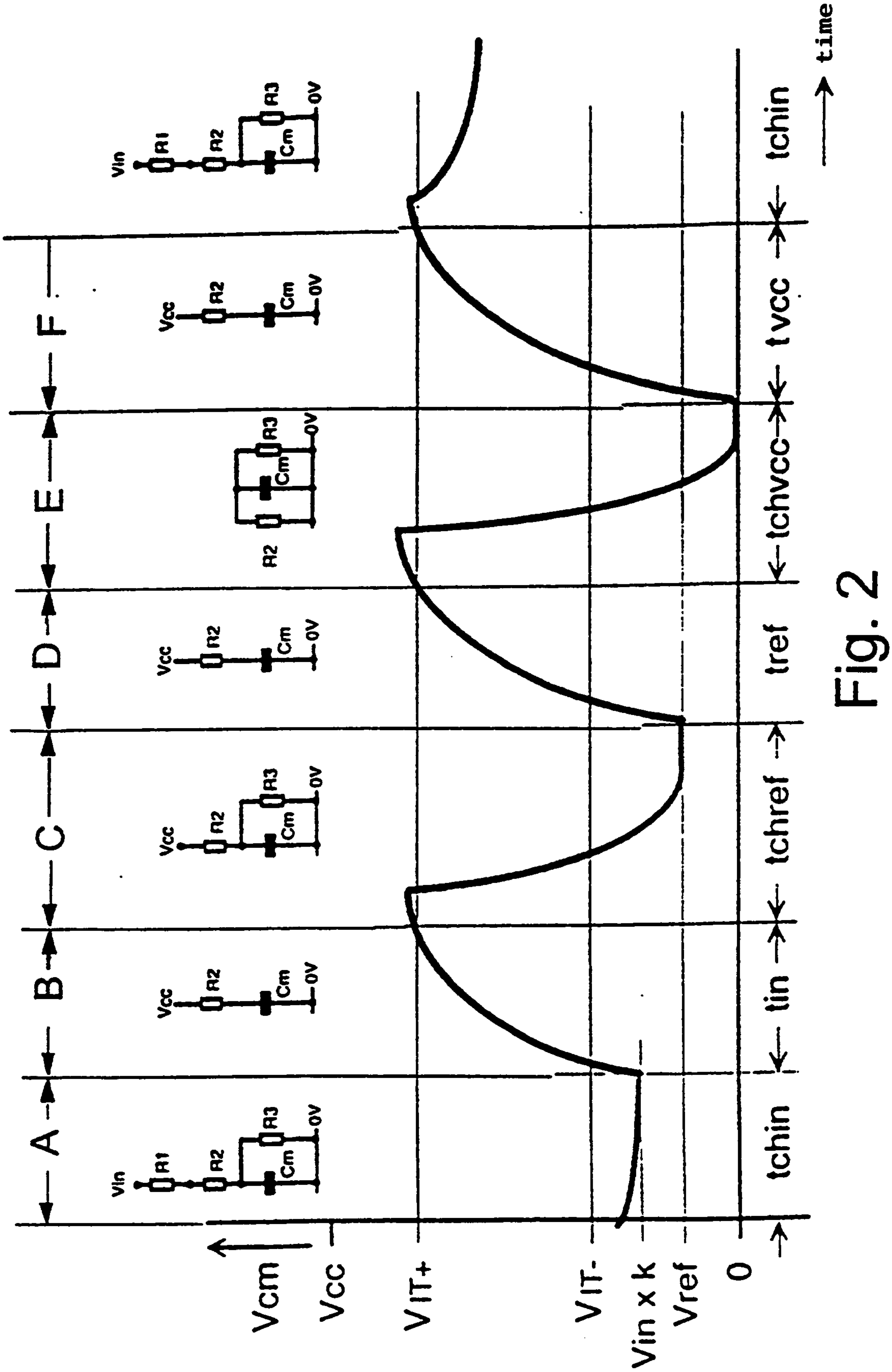

Vcm
Vcc
VIT+
VIT-
Vin x k
Vref
0
A
B
C
D
E
F
tchin
tin
tchref
tref
tchvcc
tvcc
tchin
time
Vin
R1
R2
R3
Cm
0V
Vcc


Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 0884600 A


### Non-patent literature cited in the description


- *electronic industry,* 1999, vol. 2, 24-32